(19) Europäisches Patentamt
European Patent Office
Office européen des brevets

(11) **EP 4 072 012 A1**

(12) **EUROPEAN PATENT APPLICATION**
published in accordance with Art. 153(4) EPC

(43) Date of publication:
**12.10.2022 Bulletin 2022/41**

(51) International Patent Classification (IPC):
**H03H 7/01** (2006.01)  **H03F 3/20** (2006.01)
**H01P 5/16** (2006.01)

(21) Application number: **19958478.0**

(52) Cooperative Patent Classification (CPC):
**H01P 5/16; H03F 3/20; H03H 7/01**

(22) Date of filing: **31.12.2019**

(86) International application number:
**PCT/CN2019/130260**

(87) International publication number:
**WO 2021/134383 (08.07.2021 Gazette 2021/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventor: **GAO, Zongzhi
Shenzhen, Guangdong 518129 (CN)**

(74) Representative: **Maiwald Patent- und
Rechtsanwaltsgesellschaft mbH
Elisenhof
Elisenstraße 3
80335 München (DE)**

(54) **POWER DIVIDER, POWER DIVISION APPARATUS AND WIRELESS COMMUNICATION APPARATUS**

(57) This application discloses a power divider, a power dividing apparatus, and a wireless communication apparatus. The power divider includes a main port, a first branch port, and a second branch port. A first induction unit is disposed between the main port and the first branch port, and a second induction unit is disposed between the main port and the second branch port. A first transistor switch unit is disposed between the first induction unit and the ground. A second transistor switch unit is disposed between the second induction unit and the ground. A third transistor switch unit is disposed between the first branch port and the second branch port. A cut-off capacitor corresponding to the first transistor switch unit and the second transistor switch unit that are in an off state may be equivalent to a capacitor in a form of a lumped element, and an on-resistor corresponding to the third transistor switch unit that is in an on state may be equivalent to an isolation resistor in a form of a lumped resistance element. Therefore, the power divider not only has a port selection capability, but also can reduce a chip area, and is applicable to the field of integrated circuits.

FIG. 7

## Description

## TECHNICAL FIELD

This application relates to the field of integrated circuits, and in particular, to a power divider, a power dividing apparatus, and a wireless communication apparatus.

## BACKGROUND

A power divider (power divider), referred to as a power divider or splitter (splitter) for short, is a common microwave component. In a wireless communication device (for example, a base station or a terminal), an input power usually needs to be allocated to branch circuits according to a specific proportion. In this case, a power divider may be used. The power divider can be used for power allocation or power combination. In this case, the power divider is also referred to as a power combiner, or referred to as a combiner (combiner) for short. If equal power is allocated to all branch circuits, the power divider is also referred to as an equal-power divider.

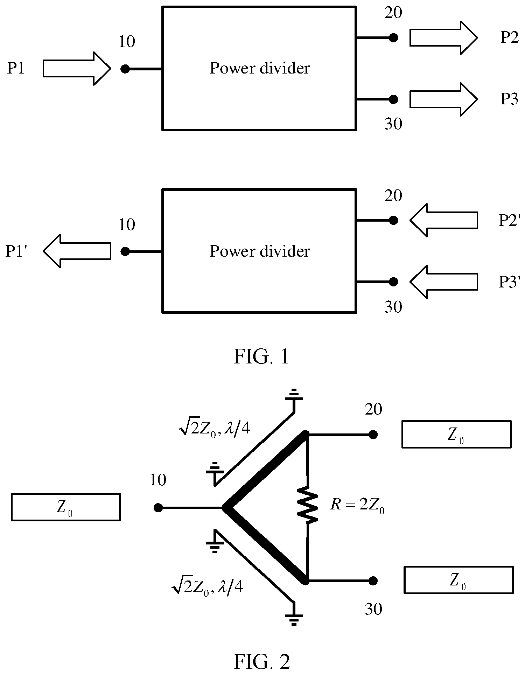

FIG. 1 is a schematic diagram of a function of a power divider. As shown in FIG. 1, the power divider includes a main port 10 and two branch ports 20 and 30. When a signal P1 with high power is input from the main port 10, a signal P2 with low power may be output from the branch port 20 of the power divider, and another signal P3 with low power may be output from the branch port 30 of the power divider. On the contrary, when two signals P2' and P3' with low power are separately input from the branch ports 20 and 30, a signal P1' with high power may also be output from the main port 10.

A loss is an important parameter of a power divider. FIG. 1 is used as an example, it is assumed that ideally the power divider has no loss, a sum of the power of P2 and P3 should be equal to the power of PI, and the power of P1' should also be equal to a sum of the power of P2' and P3'. In an actual situation, the power divider has a specific loss. The sum of the power of P2 and P3 is less than the power of PI, and the power of P1' is also less than the sum of the power of P2' and P3'. Isolation is another important parameter of the power divider. FIG. 1 is still used as an example. It is assumed that a signal is input from the branch port 20. Generally, it is expected that the signal is output from the main port 10 as much as possible, and is not output from the other branch port 30. In other words, signal leakage is avoided. The isolation between the branch ports is a parameter for evaluating the signal leakage. Higher isolation indicates less signal leakage, and lower isolation indicates more signal leakage.

FIG. 2 is a schematic diagram of a structure of a Wilkinson (wilkinson) power divider. The Wilkinson power divider is a classic power divider designed based on transmission lines. As shown in FIG. 2, the Wilkinson power divider includes a main port 10, two branch ports 20 and 30, a first transmission line between the main port 10 and the branch port 20, a second transmission line between the main port 10 and the branch port 30, and an isolation resistor R between the branch port 20 and the branch port 30, and impedances are denoted as $2Z_0$. The first transmission line and the second transmission line should be symmetrically designed. Characteristic impedances of the first transmission line and the second transmission line are required to be equal, and both are denoted as $\sqrt{2}Z_0$. Lengths of the first transmission line and the second transmission line are required to be 1/4 of a wavelength corresponding to a to-be-transmitted signal, and both are denoted as $\lambda/4$. A size of the isolation resistor R is required to be much less than the wavelength corresponding to the to-be-transmitted signal, and may be almost ignored. When the Wilkinson power divider works, the main port 10, the branch port 20, and the branch port 30 are respectively connected to three transmission lines whose characteristic impedances are also denoted as $Z_0$, and can meet an impedance matching condition required for signal transmission.

A signal that is input from the main port 10 separately passes through the first transmission line and the second transmission line that have a same length ($\lambda/4$), and arrives at two ends of the isolation resistor R. Then, two signals whose amplitudes and phases are theoretically equal are output from the branch port 20 and the branch port 30. It can be easily learned that the Wilkinson power divider is also an equal-power divider. Because the amplitudes and phases of the signals at two ends of the isolation resistor R are equal, there should be no differential mode signal on the isolation resistor R. Therefore, theoretically the Wilkinson power divider has no power loss. Certainly, due to factors such as materials of the Wilkinson power divider and non-ideal signal transmission, some power losses still exist in actual working of the Wilkinson power divider.

In addition, due to existence of the isolation resistor R, when signals are input from the branch port 20, one part of signals arrive at the branch port 30 through the isolation resistor R, and the other part of signals arrive at the branch port 30 through the first transmission line and the second transmission line whose lengths are $\lambda/4$. The amplitudes of the two parts of signals are almost equal, but a phase difference caused by a distance difference ($\lambda/2$, corresponding to two pieces of $\lambda/4$) is $\pi$, that is, the phases are opposite, and therefore the two parts of signals exactly cancel each other out. In this way, the signals input from the branch port 20 are hardly output from the branch port 30. Therefore, the existence of the isolation resistor R can effectively reduce the signal leakage and improve the isolation between the branch ports.

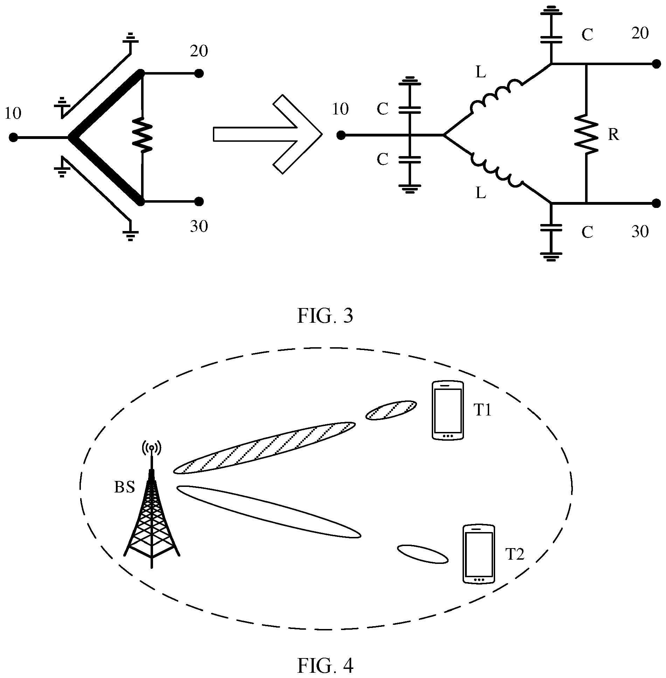

FIG. 3 is a schematic diagram of a structure of another Wilkinson power divider. The Wilkinson power divider is designed based on a lumped element. Compared with the Wilkinson power divider shown in FIG. 2, the Wilkinson power divider in FIG. 3 replaces a transmission line structure in the Wilkinson power divider with a capacitor-inductor-capacitor structure (C-L-C structure) of an equivalent lumped element. This is because quarter-wavelength transmission lines require a very large chip area for an integrated circuit, and capacitors and inductors of the equivalent lumped element require a very small chip area. However, with evolution of wireless communication technologies and integrated circuit technologies, a requirement for performance or integration of a power divider is increasingly high, and a more advanced and better power divider still needs to be continuously researched.

## SUMMARY

Embodiments of this application provide a novel power divider. The power divider has some excellent performance applicable to the field of integrated circuits. These performance indicators include but are not limited to one or more of the following: port selection capability, port isolation, layout, chip area, and the like. In addition, embodiments of this application further provide a power dividing apparatus and a wireless communication apparatus. The power dividing apparatus and the wireless communication apparatus may include one or more power dividers.

According to a first aspect, a power divider is provided, including a main port, a first branch port, and a second branch port. The main port, the first branch port, and the second branch port may be single ports or differential ports. A first induction unit is disposed between the main port and the first branch port, a first end of the first induction unit is connected to the main port, and a second end of the first induction unit is connected to the first branch port. A second induction unit is disposed between the main port and the second branch port, a first end of the second induction unit is connected to the main port, and a second end of the second induction unit is connected to the second branch port.

In addition, the power divider further includes a first transistor switch unit, a second transistor switch unit, and a third transistor switch unit. A first end of the first transistor switch unit is connected to the second end of the first induction unit, a second end of the first transistor switch unit is grounded, and the first transistor switch unit is configured to control whether the second end of the first induction unit is grounded. A first end of the second transistor switch unit is connected to the second end of the second induction unit, a second end of the second transistor switch unit is grounded, and the second transistor switch unit is configured to control whether the second end of the second induction unit is grounded. A first end of the third transistor switch unit is directly connected to the second end of the first induction unit, a second end of the third transistor switch unit is directly connected to the second end of the second induction unit, and the third transistor switch unit is configured to control whether the second end of the first induction unit is connected to the second end of the second induction unit.

It should be understood that these transistor switch units (the first transistor switch unit, the second transistor switch unit, and the third transistor switch unit) in the power divider may be understood as basic units that include one or more transistors and that have a switch function. In addition to providing the switch function, these transistor switch units can further provide an equivalent capacitor or an equivalent resistor based on transistor features (for example, a cut-off capacitor corresponding to an off state and an on-resistor corresponding to an on state) of the transistor switch units, thereby reducing a requirement for additionally disposing a capacitor or a resistor in a form of a lumped element. For example, the first end of the third transistor switch unit being directly connected to the second end of the first induction unit may be understood as that the first end of the third transistor switch unit is in direct contact with the second end of the first induction unit or is connected to the second end of the first induction unit through a transmission line or a conducting wire, without a need to additionally dispose the resistor in a form of a lumped element. A resistance value of the transmission line or the conducting wire between the first end of the third transistor switch unit and the second end of the first induction unit is negligible compared with that of the resistor in a form of a lumped element. The second end of the third transistor switch unit is also directly connected to the second end of the second induction unit in a same way.

Therefore, according to this technical solution, a cut-off capacitor corresponding to the first transistor switch unit and the second transistor switch unit that are in an off state may be equivalent to a capacitor in a form of a lumped element, and an on-resistor corresponding to the third transistor switch unit that is in an on state may be equivalent to an isolation resistor in a form of a lumped resistance element, without a need to additionally dispose the resistor in a form of a lumped element. Therefore, the power divider not only has a port selection capability, but also can reduce a chip area, and is applicable to the field of integrated circuits.

In an optional implementation, the first transistor switch unit, the second transistor switch unit, and the third transistor switch unit each include a MOS transistor. In another optional implementation, the first transistor switch unit, the second transistor switch unit, and the third transistor switch unit each include a BJT transistor.

More specifically, the MOS transistor is used as an example. The power divider may use an N-type MOS transistor, a P-type MOS transistor, or a CMOS transistor (the N-type MOS transistor and the P-type MOS transistor) as a basic component of the first transistor switch unit, the second transistor switch unit, and the third transistor switch unit. The N-type MOS transistor is used as the basic component, which facilitates sharing of a same substrate by a plurality of N-type MOS transistors in the power divider or even a chip, and can simplify connection complexity of substrate potential (that is, "ground"), thereby reducing design difficulty and manufacturing costs.

In an optional implementation, the third transistor switch unit includes a MOS transistor.

The first end of the third transistor switch unit is either of a source electrode and a drain electrode of the MOS transistor, the second end of the third transistor switch unit is the other of the source electrode and the drain electrode of the MOS transistor, and a gate electrode of the MOS transistor is configured to receive a switch control signal of the third transistor switch unit.

According to the optional technical solution, when a same isolation resistor requirement (for example, 100 ohms) is met, the resistor in a form of a lumped element may not be disposed, and a MOS transistor having a small size (for example, a channel width-to-length ratio) may be selected, which not only can reduce a layout and a chip area, but also can improve port isolation in a port selection mode.

In an optional implementation, the third transistor switch unit includes two serially-connected metal oxide semiconductor MOS transistors. The two serially-connected MOS transistors include a first MOS transistor and a second MOS transistor. A source electrode of the first MOS transistor is connected to a drain electrode of the second MOS transistor.

The first end of the third transistor switch unit is a drain electrode of the first MOS transistor or a source electrode of the second MOS transistor, and the second end of the third transistor switch unit is a source electrode of the second MOS transistor or the drain electrode of the first MOS transistor. Gate electrodes of the first MOS transistor and the second MOS transistor are separately configured to receive a switch control signal of the third transistor switch unit.

Compared with the foregoing optional technical solution, this optional technical solution can further improve port isolation in a port selection mode although a layout and a chip area increase due to an increase in a quantity of transistors.

In an optional implementation, the third transistor switch unit includes a plurality of serially-connected metal oxide semiconductor MOS transistors. A source electrode and a drain electrode of each of the plurality of serially-connected metal oxide semiconductor MOS transistors are connected to each other. The first end of the third transistor switch unit is a source electrode or a drain electrode of one MOS transistor, and the second end of the third transistor switch unit is a drain electrode or a source electrode of another MOS transistor. A gate electrode of each of the plurality of serially-connected metal oxide semiconductor MOS transistors is configured to receive a switch control signal of the third transistor switch unit.

In an optional implementation, the third transistor switch unit includes a plurality of metal oxide semiconductor MOS transistors connected in parallel. The first end of the third transistor switch unit is a source electrode or a drain electrode of each of the plurality of metal oxide semiconductor MOS transistors connected in parallel, and the second end of the third transistor switch unit is a drain electrode or a source electrode of each of the plurality of metal oxide semiconductor MOS transistors connected in parallel. A gate electrode of each of the plurality of metal oxide semiconductor MOS transistors connected in parallel is configured to receive a switch control signal of the third transistor switch unit.

Compared with the foregoing optional technical solution, this optional technical solution can reduce a layout and a chip area to some extent although port isolation in a port selection mode is reduced.

In an optional implementation, a channel width-to-length ratio of the MOS transistor in the third transistor switch unit is less than a channel width-to-length ratio of the MOS transistor in the first transistor switch unit and a channel width-to-length ratio of the MOS transistor in the second transistor switch unit. According to this optional technical solution, a MOS transistor having a small size (a channel width-to-length ratio) is selected, so that a layout and a chip area can be reduced. In addition, an equivalent on-resistor is large, which helps meet a requirement for an isolation resistor. A parasitic capacitor is small, which helps further improve port isolation in a port selection mode.

In an optional implementation, a characteristic impedance value of a transmission line connected to the main port, the first branch port, and the second branch port of the power divider is Z ohms, and a value of an equivalent on-resistor of the third transistor switch unit is 2Z ohms. For example, when the characteristic impedance value of the transmission line is 50 ohms, a value of the equivalent on-resistor of the third transistor switch unit is 100 ohms. When the characteristic impedance value of the transmission line is 75 ohms, a value of the equivalent on-resistor of the third transistor switch unit is 150 ohms.

In an optional implementation, when the first transistor switch unit is in an off state, the second transistor switch unit is in an off state, and the third transistor switch unit is in an on state, the main port and the first branch port are connected to each other by using the first induction unit, and the main port and the second branch port are connected to each other by using the second induction unit. In this case, the power divider may be considered to be in a conventional power divider mode.

In an optional implementation, when the first transistor switch unit is in an off state, the second transistor switch unit is in an on state, and the third transistor switch unit is in an off state, the main port and the first branch port are connected to each other by using the first induction unit, the second end of the second induction unit is grounded, and the main port and the second branch port are isolated from each other. In this case, the power divider may be considered to be in a port selection mode, which is equivalent to that the first branch port is selected, or in other words, the first branch port is in a pass-through mode.

In an optional implementation, when the first transistor switch unit is in an on state, the second transistor switch unit is in an off state, and the third transistor switch unit is in an off state, the second end of the first induction unit is grounded, the main port and the first branch port are isolated from each other, and the main port and the second branch port are connected to each other by using the second induction unit. In this case, the power divider may be considered to be in another port selection mode, which is equivalent to that the second branch port is selected, or in other words, the second branch port is in a pass-through mode.

According to a second aspect, a power divider is further provided. The power divider includes a main port, a first branch port, a second branch port, a first transistor switch unit, and a second transistor switch unit.

It should be understood that the main port, the first branch port, and the second branch port may be single ports or differential ports. A first induction unit is disposed between the main port and the first branch port, a first end of the first induction unit is connected to the main port, and a second end of the first induction unit is connected to the first branch port. A second induction unit is disposed between the main port and the second branch port, a first end of the second induction unit is connected to the main port, and a second end of the second induction unit is connected to the second branch port. A first end of the first transistor switch unit is connected to the second end of the first induction unit, a second end of the first transistor switch unit is grounded, and the first transistor switch unit is configured to control whether the second end of the first induction unit is grounded. A first end of the second transistor switch unit is connected to the second end of the second induction unit, a second end of the second transistor switch unit is grounded, and the second transistor switch unit is configured to control whether the second end of the second induction unit is grounded.

In addition, the power divider further includes a third metal oxide semiconductor MOS transistor. One of a source electrode and a drain electrode of the third MOS transistor is directly connected to the second end of the first induction unit, the other of the source electrode and the drain electrode of the third MOS transistor is directly connected to the second end of the second induction unit, and a gate electrode of the third MOS transistor is configured to receive a switch control signal, to control whether the second end of the first induction unit is connected to the second end of the second induction unit.

It should be understood that the third MOS transistor in the power divider provided in the second aspect may also be considered as a specific example of a third transistor switch unit in the power divider provided in the first aspect. For related content, refer to the content in the first aspect and any implementation. Details are not described herein again. For example, for "direct connection" of the source electrode or the drain electrode of the third MOS transistor, refer to the first aspect.

According to a third aspect, a power divider is further provided. The power divider includes a main port, a first branch port, a second branch port, a first transistor switch unit, and a second transistor switch unit.

It should be understood that the main port, the first branch port, and the second branch port may be single ports or differential ports. A first induction unit is disposed between the main port and the first branch port, a first end of the first induction unit is connected to the main port, and a second end of the first induction unit is connected to the first branch port. A second induction unit is disposed between the main port and the second branch port, a first end of the second induction unit is connected to the main port, and a second end of the second induction unit is connected to the second branch port. A first end of the first transistor switch unit is connected to the second end of the first induction unit, a second end of the first transistor switch unit is grounded, and the first transistor switch unit is configured to control whether the second end of the first induction unit is grounded. A first end of the second transistor switch unit is connected to the second end of the second induction unit, a second end of the second transistor switch unit is grounded, and the second transistor switch unit is configured to control whether the second end of the second induction unit is grounded.

In addition, the power divider further includes two serially-connected first MOS transistors and second MOS transistors. A source electrode of the first MOS transistor is directly connected to a drain electrode of the second MOS transistor, a drain electrode of the first MOS transistor is directly connected to the second end of the first induction unit, a source electrode of the second MOS transistor is directly connected to the second end of the second induction unit, and gate electrodes of the first MOS transistor and the second MOS transistor are separately configured to receive a switch control signal, to control whether the second end of the first induction unit is connected to the second end of the second induction unit.

It should be understood that a combination of the first MOS transistor and the second MOS transistor in the power divider provided in the third aspect may also be considered as a specific example of a third transistor switch unit in the power divider provided in the first aspect. For related content, refer to the content in the first aspect and any implementation. Details are not described herein again. For example, for "direct connection" herein, refer to the first aspect.

According to a fourth aspect, a power dividing apparatus is further provided, including at least three power dividers according to the first aspect or any one of the optional implementations. Each of the at least three power dividers includes a main port, a first branch port, and a second branch port. The at least three power dividers include a first power divider, a second power divider, and a third power divider. The first branch port of the first power divider is connected to the main port of the second power divider, and the second branch port of the first power divider is connected to the main port of the third power divider.

According to a fifth aspect, a wireless communication apparatus is further provided, including a transceiver and the power dividing apparatus according to the second aspect. A main port of a first power divider is coupled to the transceiver through a circuit.

In an optional implementation, the wireless communication apparatus further includes an antenna array. The antenna array includes a first antenna unit, a second antenna unit, a third antenna unit, and a fourth antenna unit. A first branch port of a second power divider is coupled to the first antenna unit, and a second branch port of the second power divider is coupled to the second antenna unit. A first branch port of a third power divider is coupled to the third antenna unit, and a second branch port of the third power divider is coupled to the fourth antenna unit.

In an optional implementation, the wireless communication apparatus further includes: a control circuit, configured to output respective switch control signals of a first transistor switch unit, a second transistor switch unit, and a third transistor switch unit. On this basis, in an optional implementation, the wireless communication apparatus includes a radio frequency chip and a baseband chip. The control circuit is integrated into the baseband chip. The power dividing apparatus is integrated into the radio frequency chip. In another optional implementation, the wireless communication apparatus includes a radio frequency chip. Both the control circuit and the power dividing apparatus are integrated into the radio frequency chip.

According to a sixth aspect, a wireless communication apparatus is further provided, including a transceiver and the power divider according to the first aspect, the second aspect, the third aspect, or any one of the foregoing optional implementations. A main port of the power divider is coupled to the transceiver through a circuit.

It should be understood that in the solutions provided in this application, the wireless communication apparatus may be a wireless communication device, or may also be some components in the wireless communication device, for example, an integrated circuit product such as a radio frequency component, a radio frequency chip, a chipset, or a module including a chip. The wireless communication device may be a computer device that supports a wireless communication function.

Specifically, the wireless communication device may be a terminal such as a smartphone, or may be a radio access network device such as a base station. In terms of functions, chips used for wireless communication may be classified into a baseband chip and a radio frequency chip. The baseband chip is also referred to as a modem (modem) or a baseband processing chip. The radio frequency chip is also referred to as a transceiver chip, a radio frequency transceiver (transceiver), or a radio frequency processing chip. Therefore, the wireless communication apparatus may be a single chip, or may be a combination of a plurality of chips, for example, a system chip, a chip platform, or a chipset.

The system chip is also referred to as a system on a chip (system on a chip, SoC), or referred to as a SoC chip for short. It may be understood that the plurality of chips are packaged together to form a larger chip. For example, the baseband chip may be further packaged in the SoC chip. The chip platform or chipset may be understood as a plurality of chips that need to be used together. The plurality of chips are usually separately packaged, but the chips need to cooperate with each other during working to complete a wireless communication function together. For example, the baseband chip (or a SoC chip integrated with the baseband chip) and the radio frequency chip are usually separately packaged, but need to be used together.

## BRIEF DESCRIPTION OF DRAWINGS

FIG. 1 is a schematic diagram of a function of a power divider according to an embodiment of this application;

FIG. 2 is a schematic diagram of a structure of a Wilkinson power divider according to an embodiment of this application;

FIG. 3 is a schematic diagram of a structure of another Wilkinson power divider according to an embodiment of this application;

FIG. 4 is a schematic diagram of a structure of a wireless communication system according to an embodiment of this application;

FIG. 5 is a schematic diagram of a structure of a wireless communication device according to an embodiment of this application;

FIG. 6 is a schematic diagram of a structure of a radio frequency subsystem of a wireless communication device according to an embodiment of this application;

FIG. 7 is a schematic diagram of a structure of a power divider according to an embodiment of this application;

FIG. 8(a) and FIG. 8(b) are schematic diagrams of specific structures of power dividers according to an embodiment of this application;

FIG. 9(a) and FIG. 9(b) are schematic diagrams of a structure of an isolation resistor of a power divider according to an embodiment of this application;

FIG. 10(a), FIG. 10(b), and FIG. 10(c) are schematic diagrams of structures of an equivalent isolation resistor of a power divider according to an embodiment of this application; and

FIG. 11 is a schematic diagram of a structure of a wireless communication device according to an embodiment of this application.

It should be understood that, in the foregoing schematic diagrams, sizes, forms, and quantities of block diagrams are for reference only, and should not constitute exclusive interpretation of embodiments of this application. Relative locations and inclusion relationships between the block diagrams are merely examples of structural associations between the block diagrams, and are not intended to limit a physical connection manner in embodiments of this application. The quantity of the block diagrams is merely an example, and is not intended to limit quantities of the wireless communication devices or components in the devices in embodiments of this application.

## DESCRIPTION OF EMBODIMENTS

The following further describes technical solutions provided in this application with reference to accompanying drawings and embodiments. It should be understood that a system structure and a service scenario provided in embodiments of this application are mainly intended to explain some possible implementations of the technical solutions in this application, and should not be construed as a unique limitation on the technical solutions in this application. A person of ordinary skill in the art may know that, as a system evolves and an updated service scenario emerges, the technical solutions provided in this application are still applicable to a same or similar technical problem.

FIG. 4 is a schematic diagram of a structure of a wireless communication system according to an embodiment of this application. The wireless communication system includes at least one base station (base station, BS) and at least one terminal (terminal). As shown in FIG. 4, the wireless communication system shows a base station denoted as a BS and two terminals denoted as T1 and T2 respectively.

The base station is typically owned by an operator or an infrastructure provider, and is operated or maintained by these vendors. The base station may provide communication coverage for a specific geographical area by using an integrated or external antenna. One or more terminals in a communication coverage area of the base station may be connected to the base station. It should be understood that the base station may also be referred to as a wireless access point (access point, AP) or a transmission reception point (transmission reception point, TRP). Specifically, the base station may be a universal NodeB (generation Node B, gNB) in a 5G new radio (new radio, NR) system, an evolved NodeB (evolutional Node B, eNB) in a 4G long term evolution (long term evolution, LTE) system, or the like.

A terminal is more closely related to a user, and is also referred to as user equipment (user equipment, UE), a subscriber unit (subscriber unit, SU), or customer-premises equipment (customer-premises equipment, CPE). Compared with a base station that is usually placed at a fixed location, a terminal usually moves with the user, and is sometimes referred to as a mobile station (mobile station, MS). In addition, some network devices, for example, relay nodes (relay node, RN), may also be considered as terminals sometimes because the network devices have UE identities or belong to users. Specifically, the terminal may be a mobile phone (mobile phone), a tablet computer (tablet computer), a laptop computer (laptop computer), a wearable device (such as a watch, a band, a helmet, and glasses), and other devices having a wireless access capability, such as a car, a mobile wireless router, and various internet of things (internet of thing, IOT) devices, including various smart home devices (such as an electricity meter and a home appliance) and smart city devices (such as a surveillance camera and a street lamp).

It should be understood that the wireless communication system may also include another quantity of terminals and base stations. In addition, the wireless communication system may further include another network device, for example, a core network device. The wireless communication system may comply with a 3rd generation partnership project (third generation partnership project, 3GPP) wireless communication standard, or may comply with another wireless communication standard, for example, 802 series wireless communication standards (for example, 802.11, 802.15, or 802.20) of the Institute of Electrical and Electronics Engineers (Institute of Electrical and Electronics Engineers, IEEE).

In this embodiment of this application, the terminal and the base station need to know configurations predefined by the wireless communication system, including a radio access technology (radio access technology, RAT) supported by the system and a configuration of a radio resource stipulated by the system, for example, basic configurations of a radio band and a carrier. The configurations predefined by the system may be used as a part of a standard protocol for the wireless communication system, or may be determined through interaction between the terminal and the base station. Content of a related standard protocol may be prestored in memories of the terminal and the base station, or represented as hardware circuits or software code of the terminal and the base station.

For example, the base station and the terminal each are equipped with one or more antennas, and communicate with each other by using a radio electromagnetic wave as a transmission medium. When the radio resource stipulated by the system includes a millimeter-wave band, the base station and the terminal may be separately equipped with an antenna array. The antenna array includes a plurality of antennas, and can support a beamforming technology, to reduce a signal transmission loss, increase a signal-to-noise ratio, and improve wireless communication performance.

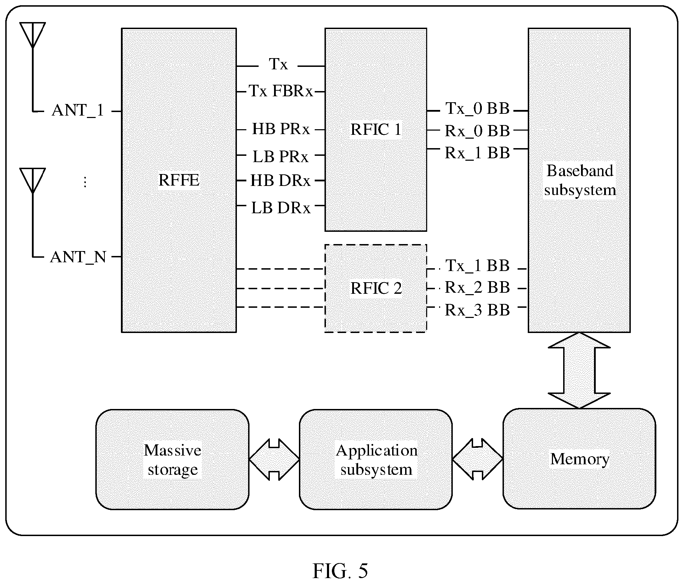

FIG. 5 is a schematic diagram of a structure of a wireless communication device according to an embodiment of this application. The wireless communication device may be a terminal or a base station in this embodiment of this application. As shown in FIG. 5, the wireless communication device may include an application subsystem, a memory (memory), a massive storage (massive storage), a baseband subsystem, a radio frequency integrated circuit (radio frequency integrated circuit, RFIC), a radio frequency front-end (radio frequency front end, RFFE) component, and an antenna (antenna, ANT). These components may be coupled to each other by using various interconnection buses or other electrical connection manners.

In FIG. 5, ANT_1 represents a first antenna, ANT N represents an $N^{th}$ antenna, and N is a positive integer greater than 1. Tx represents a transmit path, and Rx represents a receive path. Different numbers represent different paths. FBRx represents a feedback receive path, PRx represents a primary receive path, and DRx represents a diversity receive path. HB represents a high band, LB represents a low band, and HB or LB indicates that a band is comparatively high or low. BB represents a baseband. It should be understood that marks and components in FIG. 5 are merely examples, and this embodiment of this application further includes another implementation.

The application subsystem may be used as a main control system or a main computing system of the wireless communication device, and is configured to run a main operating system and an application program, manage software and hardware resources of the entire wireless communication device, and provide a user operation interface for a user. The application subsystem may include one or more processing cores, and may execute application software of the wireless communication device and driver software related to another subsystem (for example, a baseband subsystem). The baseband subsystem may also include one or more processing cores, a hardware accelerator (hardware accelerator, HAC), a cache, and the like, and may execute some program software of the baseband subsystem to complete a baseband signal processing function.

In FIG. 5, an RFFE component and an RFIC 1 (and an optional RFIC 2) may jointly form a radio frequency subsystem. The radio frequency subsystem may be further divided into a radio frequency receive channel (RF receive path) and a radio frequency transmit channel (RF transmit path). The radio frequency receive channel may receive a radio frequency signal through the antenna, perform processing (such as amplification, filtering, and down-conversion) on the radio frequency signal to obtain a baseband signal, and transfer the baseband signal to the baseband subsystem. The radio frequency transmit channel may receive the baseband signal from the baseband subsystem, perform radio frequency processing (such as up-conversion, amplification, and filtering) on the baseband signal to obtain a radio frequency signal, and finally radiate the radio frequency signal into space through the antenna. Specifically, the radio frequency subsystem may include electronic components such as an antenna switch, an antenna tuner, a low noise amplifier (low noise amplifier, LNA), a power amplifier (power amplifier, PA), a frequency mixer (mixer), a local oscillator (local oscillator, LO), and a filter (filter). The electronic components may be integrated into one or more chips based on a requirement. The antenna may also be sometimes considered as a part of the radio frequency subsystem.

The baseband subsystem may extract wanted information or data bits from the baseband signal, or convert information or data bits into a to-be-sent baseband signal. The information or data bits may be data that represents user data or control information such as a voice, a text, or video. For example, the baseband subsystem may implement modulation and demodulation, encoding and decoding, and other signal processing operations. Different radio access technologies, such as 5G NR and 4G LTE, usually have different baseband signal processing operations. Therefore, the baseband subsystem may include the plurality of processing cores or the plurality of HACs, to support convergence of a plurality of mobile communication modes.

It should be understood that in this embodiment of this application, the processing core may represent a processor; and the processor may be a general-purpose processor, or may be a processor designed for a specific field. For example, the processor may be a central processing unit (center processing unit, CPU), or may be a digital signal processor (digital signal processor, DSP). Alternatively, the processor may be a micro control unit (micro control unit, MCU), a graphics processing unit (graphics processing unit, GPU), an image signal processor (image signal processor, ISP), an audio signal processor (audio signal processor, ASP), or a processor specially designed for an artificial intelligence (artificial intelligence, AI) application. The AI processor includes but is not limited to a neural network processing unit (neural network processing unit, NPU), a tensor processing unit (tensor processing unit, TPU), and a processor referred to as an AI engine.

The memories may be classified into a volatile memory (volatile memory) and a non-volatile memory (non-volatile memory, NVM). The volatile memory is a memory in which data stored in the memory is lost after a power supply is interrupted. Currently, the volatile memories are mainly random access memories (random access memory, RAM), and include a static random access memory (static RAM, SRAM) and a dynamic random access memory (dynamic RAM, DRAM). The non-volatile memory is a memory in which data stored in the memory is not lost even if the power supply is interrupted. Common non-volatile memories include a read-only memory (read only memory, ROM), an optical disc, a magnetic disk, various memories based on a flash memory (flash memory) technology, and the like. Usually, the volatile memory may be selected as the memory, and the non-volatile memory, for example, the magnetic disk or a flash memory, may be selected as the massive storage.

In this embodiment of this application, the baseband subsystem and the radio frequency subsystem jointly form a communication subsystem, to provide a wireless communication function for the wireless communication device. Usually, the baseband subsystem is responsible for managing software and hardware resources of the communication subsystem, and may configure an operating parameter for the radio frequency subsystem. The one or more processing cores of the baseband subsystem may be integrated into one or more chips, and the chip may be referred to as a baseband processing chip or a baseband chip. Similarly, the RFIC may be referred to as a radio frequency processing chip or a radio frequency chip. In addition, with evolution of technologies, function division of the radio frequency subsystem and the baseband subsystem in the communication subsystem may alternatively be adjusted. For example, some functions of the radio frequency subsystem are integrated into the baseband subsystem, or some functions of the baseband subsystem are integrated into the radio frequency subsystem.

In this embodiment of this application, the radio frequency subsystem may include an independent antenna, an independent radio frequency front-end component, and an independent radio frequency chip. The radio frequency chip is also sometimes referred to as a receiver (receiver), a transmitter (transmitter), or a transceiver (transceiver). All of the antenna, the radio frequency front-end component, and the radio frequency processing chip may be separately manufactured and sold. Certainly, the radio frequency subsystem may also use different components or different integration manners based on requirements for power consumption and performance. For example, some components belonging to the radio frequency front-end are integrated into the radio frequency chip. In addition, the antenna, the radio frequency front-end component, and the radio frequency chip may alternatively be integrated into a same module, which is referred to as a radio frequency antenna module, a millimeter-wave antenna module, or an antenna module.

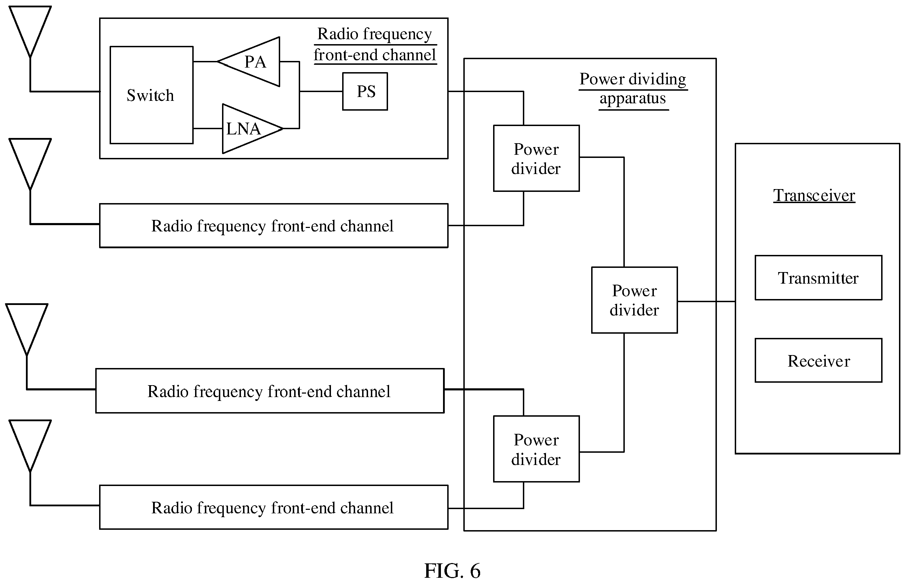

FIG. 6 is a schematic diagram of a structure of a radio frequency subsystem of a wireless communication device according to an embodiment of this application. FIG. 6 shows some common components of the radio frequency subsystem. As shown in FIG. 6, the radio frequency subsystem may include a plurality of antennas, a plurality of radio frequency front-end channels, a power dividing apparatus, and a transceiver.

Some of the plurality of antennas may form a phased antenna array, to support communication in a millimeter-wave band. The phased antenna array includes a plurality of antennas. In this case, the antenna in the phased antenna array may also be referred to as an antenna unit. By selecting the antenna unit and controlling a phase of a radio frequency signal sent or received by the antenna unit, the wireless communication device may transmit or receive an electromagnetic wave with specific directivity, which is referred to as a beam for short.

The radio frequency front-end channel includes a radio frequency front-end component, and different radio frequency front-end channels may include different radio frequency front-end components. As shown in FIG. 6, one radio frequency front-end channel may include a power amplifier PA used for a signal send path, a low noise amplifier LNA used for a signal receive path, and a switch used for selecting the signal send path or the signal receive path. When the radio frequency front-end channel is coupled to the antenna unit of the phased antenna array, the radio frequency front-end channel may further include a phase shifter (phase shifter, PS). The phase shifter may be configured to adjust a phase (a signal send path) of the radio frequency signal fed into the antenna unit, or adjust a phase (a signal receive path) of the radio frequency signal received by the antenna unit.

The transceiver may include a transmitter and a receiver, respectively configured to perform an up-conversion operation and a down-conversion operation. For communication in the millimeter-wave band, the up-conversion operation and the down-conversion operation may respectively include two or more levels of up-conversion operations and down-conversion operations. In addition, because there are a large number of radio frequency front-end channels and antenna units of the phased antenna array (for example, four or eight), and there are a small number of transceivers (for example, one or two), the radio frequency subsystem further includes the power dividing apparatus.

As shown in FIG. 6, the power dividing apparatus may include a plurality of power dividers, and these power dividers are connected to each other to jointly form a power divider network. On the signal send path, one radio frequency signal from the transceiver is divided into a plurality of radio frequency signals by the power dividing apparatus. Then, the radio frequency signals are phase shifted and amplified by the radio frequency front-end channel, and finally radiated from the plurality of antenna units of the phased antenna array. On the signal receive path, a plurality of radio frequency signals received by the plurality of antenna units of the phased antenna array are amplified and phase shifted by the radio frequency front-end channel, combined into one radio frequency signal by the power dividing apparatus, and output to the transceiver.

When the phased antenna array is used for millimeter wave communication, beams with different directivity may need to be sent or received. Therefore, the wireless communication device may select some antenna units and radio frequency front-end channels to form the signal send path or the signal receive path. In this case, for the power dividing apparatus, if some of the power dividers can be reconfigured, a power divider network of another connection structure other than a fixed connection structure may be provided, so that the wireless communication device can select some antenna units and radio frequency front-end channels. A power divider shown in FIG. 1 is used as an example. When a signal P1 is input from a main port 10, if the power divider does not have a port selection capability, the power divider outputs two signals P2 and P3. If the power divider has the port selection capability, for example, selects a branch port 20, it is equivalent to that the main port 10 is directly connected to the branch port 20, and the main port 10 and a branch port 30 are isolated from each other. In an ideal case, all signals input from the main port 10 are output from the branch port 20, and no signal is output from the branch port 30.

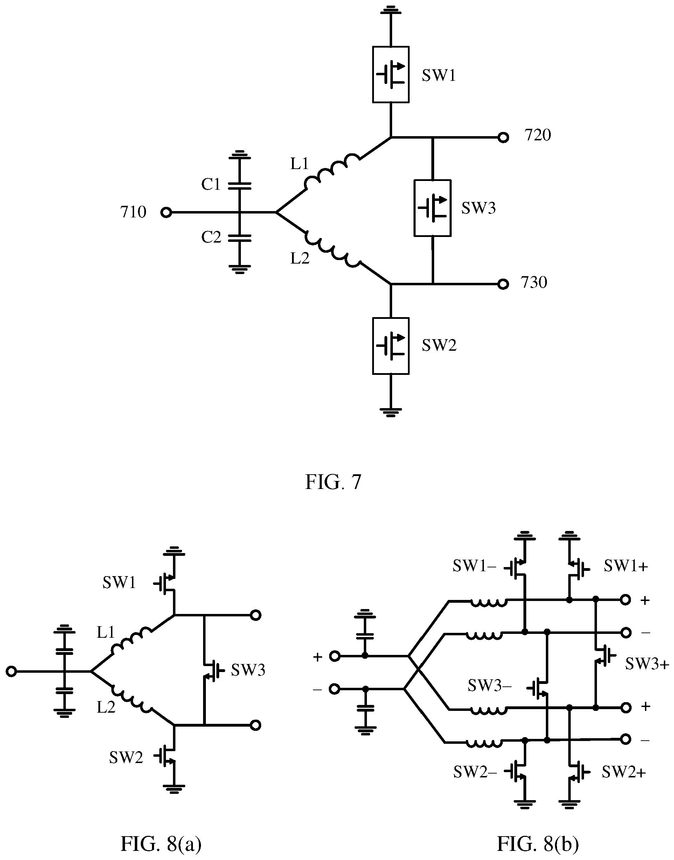

FIG. 7 is a schematic diagram of a structure of a power divider according to an embodiment of this application. The power divider has a port selection capability, and is applicable to the field of integrated circuits. For example, the power divider may be applied to a power dividing apparatus shown in FIG. 6.

As shown in FIG. 7, the power divider includes a main port 710, a first branch port 720, and a second branch port 730. A first induction unit L1 is disposed between the main port 710 and the first branch port 720. A first end of the first induction unit L1 is connected to the main port 710, and a second end of the first induction unit L1 is connected to the first branch port 720. A second induction unit L2 is disposed between the main port 710 and the second branch port 730. A first end of the second induction unit L2 is connected to the main port 710, and a second end of the second induction unit L2 is connected to the second branch port 730.

The second end of the first induction unit L1 is further connected to a first end of a first transistor switch unit SW1, and a second end of the first transistor switch unit SW1 is grounded. The first transistor switch unit SW1 is configured to control whether the second end of the first induction unit L1 is grounded. The second end of the second induction unit L2 is further connected to a first end of a second transistor switch unit SW2, and a second end of the second transistor switch unit SW2 is grounded. The second transistor switch unit SW2 is configured to control whether the second end of the second induction unit L2 is grounded. In addition, the second end of the first induction unit L1 is further connected to a first end of a third transistor switch unit SW3, and the second end of the second induction unit L2 is further connected to a second end of the third transistor switch unit SW3. The third transistor switch unit SW3 is configured to control whether the second end of the first induction unit L1 is connected to the second end of the second induction unit L2.

In an optional implementation, the first transistor switch unit, the second transistor switch unit, and the third transistor switch unit are all bipolar junction transistors (bipolar junction transistor, BJT), referred to as bipolar transistors, BJT transistors, or triodes for short.

In another optional implementation, the first transistor switch unit SW1, the second transistor switch unit SW2, and the third transistor switch unit SW3 are all metal oxide semiconductor field effect transistors (metal oxide semiconductor field effect transistor, MOSFET), referred to as MOS transistors or MOS transistors or FET transistors for short. In this case, the first transistor switch unit SW1, the second transistor switch unit SW2, and the third transistor switch unit SW3 may also respectively be denoted as a first MOS transistor switch unit, a second MOS transistor switch unit, and a third MOS transistor switch unit.

For ease of description, in the following embodiments, the MOS transistor is used as an example to describe in detail more specific solutions in embodiments of this application. However, it should be understood that solutions in embodiments of this application are also applicable to the BJT transistor. A gate electrode of the MOS transistor may correspond to a base electrode of the BJT transistor, a source electrode of the MOS transistor may correspond to an emitter electrode of the BJT transistor, and a drain electrode of the MOS transistor may correspond to a collector electrode of the BJT transistor. An N-type MOS transistor may correspond to an NPN-type BJT transistor, and a P-type MOS transistor may correspond to a PNP-type transistor.

In particular, the first transistor switch unit SW1, the second transistor switch unit SW2, the third transistor switch unit SW3, the first induction unit LI, and the second induction unit L2 may be designed and manufactured by using various integrated circuit technologies, including but not limited to a complementary metal oxide semiconductor (complementary metal oxide semiconductor, CMOS) technology, a silicon on insulator (silicon on insulator, SOI) technology, a fin field effect transistor (fin field effect transistor, FinFET) technology, a gallium nitride (GaN) process, a gallium arsenide (GaAs) process, a silicon germanium (SiGe) process, and the like.

The first transistor switch unit SW1 and the second transistor switch unit SW2 each may include one or more MOS transistors. The first transistor switch unit SW1 and the second transistor switch unit SW2 may have a same specific structure, include a same quantity and type of MOS transistors, and may be symmetrically designed to achieve better equal-power allocation. During specific implementation, the first induction unit L1 and the second induction unit L2 may also be symmetrically designed and have a same structure. The third transistor switch unit SW3 may also include one or more MOS transistors. A structure of the third transistor switch unit SW3 may be different from that of the first transistor switch unit SW1. The MOS transistors in the three transistor switch units may be of a same type, for example, all MOS transistors use the N-type MOS transistors, and may also be of different types. The quantities of the MOS transistors in the three transistor switch units may be the same. For example, one MOS transistor is used in each of the three transistor switch units. However, the three transistor switch units may not have a same quantity of MOS transistors. For example, one MOS transistor is used in the first transistor switch unit SW1 and the second transistor switch unit SW2, and a combination of two or more transistors is used in the third transistor switch unit SW3.

When both the first transistor switch unit SW1 and the second transistor switch unit SW2 are in an off state, neither the second end of the first induction unit L1 nor the second end of the second induction unit L2 is grounded. In this case, the MOS transistors in the first transistor switch unit SW1 and the second transistor switch unit SW2 are in an off state, and parasitic capacitors in an off state may be separately used as equivalent lumped capacitors. Refer to capacitors of a C-L-C structure shown in FIG. 3. In this case, if the third transistor switch unit SW3 is in an on state, the second end of the first induction unit L1 and the second end of the second induction unit L2 are connected to each other by using the third MOS transistor switch unit SW3. An equivalent on-resistor of the third MOS transistor switch unit SW3 may be used as an isolation resistor of a Wilkinson power divider. Refer to an isolation resistor shown in FIG. 2 or FIG. 3. Therefore, when both the first transistor switch unit SW1 and the second transistor switch unit SW2 are in an off state, and the third transistor switch unit SW3 is in an on state, the power divider may be equivalent to a Wilkinson power divider. In this case, the power divider may be considered to be in a conventional power divider mode.

Optionally, when the first transistor switch unit SW1 and the second transistor switch unit SW2 are symmetrically designed, the Wilkinson power divider may be used as an equal-power divider.

When the third transistor switch unit SW3 is in an off state, there is no equivalent isolation resistor between the second end of the first induction unit L1 and the second end of the second induction unit L2. In this case, the MOS transistor in the third transistor switch unit SW3 is in an off state, and mainly provides the parasitic capacitor in the off state. A size of the parasitic capacitor in the off state affects port isolation between the first branch port 720 and the second branch port 730.

Optionally, in a port selection mode, when the first transistor switch unit SW1 is in an on state, and the second transistor switch unit SW2 is in an off state, the second end of the first induction unit L1 is grounded, and the second end of the second induction unit L2 is not grounded. In this case, when a radio frequency signal is fed from the main port 710, due to factors such as impedance matching, the radio frequency signal is output only from the second branch port 730, and is not output from the first branch port 720. In other words, when the first transistor switch unit SW1 is in an on state, the second transistor switch unit SW2 is in an off state, and the third transistor switch unit SW3 is in an off state, it indicates that the second branch port 730 is selected, the main port 710 is directly connected to the second branch port 730, and the main port 710 and the first branch port 720 are isolated from each other. The port selection mode may also be sometimes referred to as a pass-through mode or a switch mode.

Optionally, in another port selection mode, when the first transistor switch unit SW1 is in an off state, the second transistor switch unit SW2 is in an on state, and the third transistor switch unit SW3 is in an off state, the second end of the first induction unit L1 is not grounded, and the second end of the second induction unit L2 is grounded. Similarly, when a radio frequency signal is fed from the main port 710, due to factors such as impedance matching, the radio frequency signal is output only from the first branch port 720, and is not output from the second branch port 730. In other words, the port selection mode indicates that the first branch port 720 is selected, the main port 710 is directly connected to the first branch port 720, and the main port 710 and the second branch port 730 are isolated from each other.

Optionally, the lumped capacitor at the other end of an equivalent C-L-C structure of the power divider shown in FIG. 7 may be disposed between the first end of the first induction unit L1 and the ground, and/or disposed between the first end of the second induction unit L2 and the ground. The lumped capacitor may be two smaller capacitors, or may be a larger capacitor. Specifically, a metal oxide metal (metal oxide metal, MOM) capacitor or a metal insulator metal (metal insulator metal, MIM) capacitor is selected as the lumped capacitor. Optionally, the other lumped capacitor of the C-L-C structure may also be completely or partially replaced with parasitic capacitors of the first induction unit L1 and the second induction unit L2. In this case, a layout and a chip area required to dispose the lumped capacitor at the other end of the equivalent C-L-C structure may be further reduced.

In conclusion, the power divider shown in FIG. 7 can be equivalent to the Wilkinson power divider by disposing the three transistor switch units, and can also provide different port selection capabilities, thereby reducing the layout and the chip area as a whole. In addition, when the MOS transistor is selected as a basic component of the transistor switch unit, a mature integrated circuit technology, such as a CMOS technology, may be used to collaborate with a digital circuit for design, thereby further reducing design and manufacturing costs of an entire chip.

FIG. 8(a) and FIG. 8(b) are schematic diagrams of a specific structure of a power divider according to an embodiment of this application. Based on the power divider shown in FIG. 7, FIG. 8(a) and FIG. 8(b) show more specific structural features of two power dividers. In an example, the power divider uses an N-type MOS transistor as a basic component of a transistor switch unit. However, it should be understood that the scope of this embodiment of this application is not limited thereto. A P-type MOS transistor or a CMOS transistor (the N-type MOS transistor and the P-type MOS transistor) may alternatively be used as a basic component of the transistor switch unit.

FIG. 8(a) shows a power divider in a single port form, and FIG. 8(b) shows a power divider in a differential port form. A signal transmission line connected to a main port, a first branch port, and a second branch port of the power divider in a differential port form shown in FIG. 8(b) may be a differential signal line. One differential signal line is equivalent to a combination of a positive signal line and a negative signal line. Therefore, the power divider in a differential port form shown in FIG. 8(b) is equivalent to including two power divider units of a same structure. For each power divider unit, refer to the power divider shown in FIG. 7 or FIG. 8(a). In the two power divider units, one power divider unit is configured to connect a positive signal line of a differential signal, and the other power divider unit is configured to connect a negative signal line of the differential signal.

As shown in FIG. 8(a), a first transistor switch unit SW1, a second transistor switch unit SW2, and a third transistor switch unit SW3 each are one N-type MOS transistor, and are respectively denoted as an NMOS transistor 1, an NMOS transistor 2, and an NMOS transistor 3. Source electrodes of the NMOS transistor 1 and the NMOS transistor 2 are separately grounded, and drain electrodes of the NMOS transistor 1 and the NMOS transistor 2 are respectively connected to a second end of a first induction unit L1 and a second end of a second induction unit L2. A source electrode of the NMOS transistor 3 is connected to the second end of the second induction unit L2, and a drain electrode of the NMOS transistor 3 is connected to the second end of the first induction unit L1. Gate electrodes of these NMOS transistors may receive respective switch control signals.

During specific implementation, parameters of the NMOS transistor 1 and the NMOS transistor 2 are selected mainly based on a requirement of a parasitic capacitor, and a parameter of the NMOS transistor 3 is selected mainly based on a requirement of an isolation resistor. In an optional solution, a value of an equivalent on-resistor of the third transistor switch unit may be set to 100 ohms, to achieve good impedance matching. In this case, for one NMOS transistor 3, a value of an equivalent on-resistor of the NMOS transistor 3 may be 100 ohms by setting a proper parameter, for example, a channel width-to-length ratio.

In an optional solution, a channel width-to-length ratio of the NMOS transistor 3 is less than a channel width-to-length ratio of the NMOS transistor 1 and a channel width-to-length ratio of the NMOS transistor 2. For example, it is assumed that the channel width-to-length ratio of the NMOS transistor 1 is the same as that of the NMOS transistor 2, and the channel width-to-length ratio of the NMOS transistor 3 is less than one fifth of the channel width-to-length ratio of the NMOS transistor 1. According to this optional technical solution, an NMOS transistor 3 having a small size (a channel width-to-length ratio) is selected, so that a layout and a chip area can be reduced. In addition, an equivalent on-resistor is large, which helps meet a requirement for an isolation resistor.

A parasitic capacitor is small, which helps improve port isolation in a port selection mode.

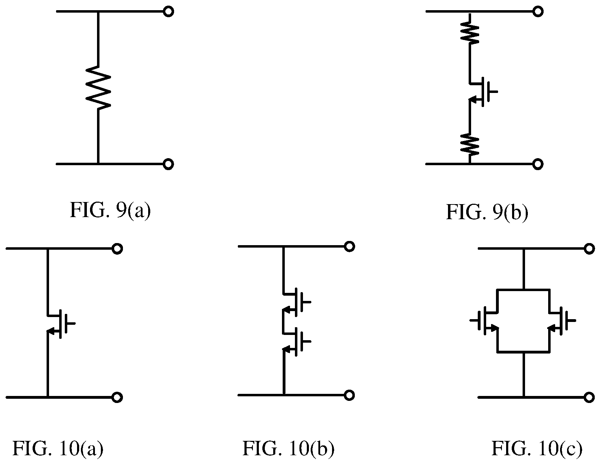

FIG. 9(a) and FIG. 9(b) are schematic diagrams of structures of an isolation resistor of a power divider according to an embodiment of this application. FIG. 9(a) and FIG. 9(b) show schematic diagrams of structures of two specific implementation solutions of the isolation resistor in a comparison manner. FIG. 9(a) is a schematic diagram of a structure of a lumped resistor serving as the isolation resistor. FIG. 9(b) is a schematic diagram of a structure of a combination of one MOS transistor and two lumped resistors that jointly serve as the isolation resistor.

By comparison, the solution shown in FIG. 9(a) in which one lumped resistor is used as the isolation resistor does not have a port selection capability. As shown in FIG. 9(b), the combination of one MOS transistor and two lumped resistors has the port selection capability. In the field of integrated circuits, a layout and a chip area required to implement the lumped resistor are usually larger than those required to implement the MOS transistor. In addition, a layout and a chip area required to implement a lumped resistor with a small resistance value are usually greater than those required to implement a lumped resistor with a large resistance value. For example, one lumped resistor with a small resistance value requires parallel connection of a plurality of lumped resistors with a large resistance value. Therefore, if the isolation resistor shown in FIG. 9(a) and the isolation resistor shown in FIG. 9(b) have a same requirement, a layout and a chip area required by a solution of the isolation resistor shown in FIG. 9(b) are obviously greater than a layout and a chip area required by a solution of the isolation resistor shown in FIG. 9(a).

FIG. 10(a), FIG. 10(b), and FIG. 10(c) are schematic diagrams of structures of an equivalent isolation resistor of a power divider according to an embodiment of this application. FIG. 10(a), FIG. 10(b), and FIG. 10(c) show schematic diagrams of structures of three specific implementation solutions of the equivalent isolation resistor in a comparison manner. FIG. 10(a) is a schematic diagram of a structure in which one MOS transistor is used as the isolation resistor, for example, solutions shown in FIG. 8(a) and FIG. 8(b). FIG. 10(b) is a schematic diagram of a structure in which two MOS transistors are serially connected as the isolation resistor. FIG. 10(c) is a schematic diagram of a structure in which two MOS transistors connected in parallel as the isolation resistor. It should be understood that FIG. 10(a), FIG. 10(b), and FIG. 10(c) are merely used as some embodiments of the third transistor switch unit SW3 in embodiments of this application. The scope of embodiments of this application is not limited thereto. For the equivalent isolation resistor, embodiments of this application may further include more transistors, different types of transistors, and another combination structure with a combination of parallel connection and series connection.

It should be understood that the equivalent isolation resistor shown in FIG. 10(a), FIG. 10(b), and FIG. 10(c) enables, based on a transistor feature, an on-resistor corresponding to the transistor that is in an on state to be equivalent to a resistor in a form of a lumped element. Compared with the isolation resistor shown in FIG. 9(a) and FIG. 9(b), although the equivalent isolation resistor is functionally equivalent to the isolation resistor, the equivalent isolation resistor can reduce a requirement for additionally disposing the resistor in a form of a lumped element, and therefore can effectively reduce a layout and a chip area.

A solution shown in FIG. 10(a) is used as an example. Compared with the solution shown in FIG. 9(b), it is assumed that overall impedances required by the isolation resistors are equal. Because there are two additional lumped resistors in the solution shown in FIG. 9(b), the equivalent on-resistor of the MOS transistor in the solution shown in FIG. 9(b) is also less than the equivalent on-resistor of the MOS transistor in the solution shown in FIG. 10(a). Therefore, a size (for example, a channel width-to-length ratio) of the MOS transistor in the solution shown in FIG. 10(a) can be less than a size of the MOS transistor in the solution shown in FIG. 9(b). Therefore, a layout and a chip area can be further reduced. In addition, because the size of the MOS transistor in the solution shown in FIG. 10(a) is smaller, a parasitic capacitor corresponding to an off state is also smaller, so that port isolation in a port selection mode can be further improved.

In the solution shown in FIG. 10(b), two MOS transistors are connected in series. In an on state, the two MOS transistors are equivalent to two equivalent on-resistors connected in series. In an off state, the two MOS transistors are equivalent to two parasitic capacitors connected in series. Compared with the solution shown in FIG. 10(a), although the layout and the chip area increase due to an increase in a quantity of transistors, the solution shown in FIG. 10(b) can further improve the port isolation in the port selection mode due to a decrease in the parasitic capacitor.

In the solution shown in FIG. 10(c), two MOS transistors are connected in parallel. In an on state, the two MOS transistors are equivalent to two equivalent on-resistors connected in parallel. In an off state, the two MOS transistors are equivalent to two parasitic capacitors connected in parallel. Compared with the solution shown in FIG. 10(b), because the parasitic capacitor is increased, the solution shown in FIG. 10(c) may reduce the port isolation in the port selection mode. However, because a size of a single MOS transistor may be smaller, a layout and a chip area may be reduced to some extent.

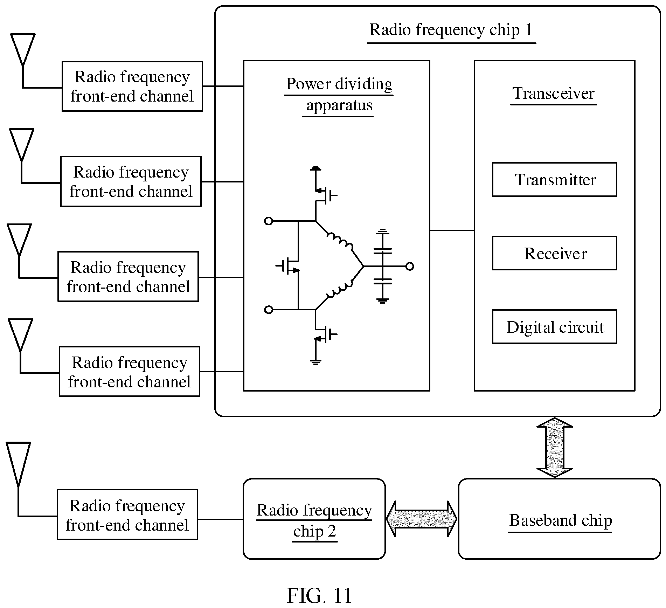

FIG. 11 is a schematic diagram of a structure of a wireless communication device according to an embodiment of this application. As shown in FIG. 11, the wireless communication device includes at least one baseband chip, at least one radio frequency chip, a plurality of radio frequency front-end channels, and a plurality of antennas. For a purpose of illustration, FIG. 11 shows two radio frequency chips (denoted as a radio frequency chip 1 and a radio frequency chip 2), five radio frequency channels, and five antennas. It should be understood that this embodiment of this application is not limited thereto. A plurality of antennas coupled to the radio frequency chip 1 may form an antenna array, to support millimeter-wave communication. The radio frequency chip 1 and a plurality of radio frequency front-end channels and antennas coupled to the radio frequency chip 1 may be further integrated into one module. The module may be referred to as an antenna module or a millimeter-wave module. In addition, the wireless communication device may further include another radio frequency chip 2, a radio frequency front-end channel, and an antenna, to support communication in another band, for example, a 4G LTE band and a sub-6G band in 5G.

As shown in FIG. 11, the baseband chip is separately coupled to the radio frequency chip 1 and the radio frequency chip 2, and may configure operating parameters for the radio frequency chip 1 and the radio frequency chip 2. Specifically, the baseband chip may include a control circuit. The control circuit may be configured to provide a switch control signal for a power dividing apparatus integrated into the radio frequency chip 1, so that a power division network structure corresponding to the power dividing apparatus can be flexibly configured according to a wireless communication requirement, for example, a conventional power divider mode or a different port selection mode is selected. In addition, a transceiver integrated into the radio frequency chip 1 may also include a digital circuit. In a possible alternative or supplementary implementation, some or all structures of the control circuit may also be integrated into the digital circuit of the radio frequency chip 1.

In embodiments of this application and accompanying drawings, the terms "first", "second", "third", and the like are intended to distinguish between similar objects but do not necessarily indicate a specific order or sequence. In addition, the terms "include", "have", and any other variants thereof are intended to indicate non-exclusive inclusions, for example, including a series of steps or units. The method, system, product, or device is not limited to the steps or units that are literally listed, but may include other steps or units that are not literally listed or that are inherent to these processes, methods, products, or devices.

It should be understood that in this application, "at least one" refers to one or more, and "a plurality of' refers to two or more. The term "and/or" is used to describe an association relationship between associated objects, and indicates that three relationships may exist. For example, "A and/or B" may indicate the following three cases: Only A exists, only B exists, and both A and B exist, where A and B may be singular or plural. The character "/" generally represents an "or" relationship between the associated objects. "At least item (piece) of the following" or a similar expression thereof means any combination of these items, including a single item (piece) or any combination of plural items (pieces). For example, at least one item (piece) of a, b, or c may indicate a, b, c, "a and b", "a and c", "b and c", or "a, b, and c", where a, b, and c may be singular or plural.

It should be understood that sequence numbers of the foregoing processes do not mean execution sequences in this application. The execution sequences of the processes should be determined according to functions and internal logic of the processes, and should not be construed as any limitation on the implementation processes of embodiments of this application. The term "coupling" mentioned in this application is used to indicate interworking or interaction between different components, and may include a direct connection or an indirect connection performed by using another component.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

**Claims**

1. A power divider, comprising:

   a main port, a first branch port, and a second branch port;
   a first induction unit, wherein a first end of the first induction unit is connected to the main port, and a second end of the first induction unit is connected to the first branch port;
   a second induction unit, wherein a first end of the second induction unit is connected to the main port, and a second end of the second induction unit is connected to the second branch port;
   a first transistor switch unit, wherein a first end of the first transistor switch unit is connected to the second end of the first induction unit, a second end of the first transistor switch unit is grounded, and the first transistor switch unit is configured to control whether the second end of the first induction unit is grounded;
   a second transistor switch unit, wherein a first end of the second transistor switch unit is connected to the second end of the second induction unit, a second end of the second transistor switch unit is grounded, and the second transistor switch unit is configured to control whether the second end of the second induction unit is grounded; and
   a third transistor switch unit, wherein a first end of the third transistor switch unit is directly connected to the second end of the first induction unit, a second end of the third transistor switch unit is directly connected to the second end of the second induction unit, and the third transistor switch unit is configured to control whether the second end of the first induction unit is connected to the second end of the second induction unit.

2. The power divider according to claim 1, wherein

   the third transistor switch unit comprises a metal oxide semiconductor MOS transistor; and
   The first end of the third transistor switch unit is either of a source electrode and a drain electrode of the MOS transistor, the second end of the third transistor switch unit is the other of the source electrode and the drain electrode of the MOS transistor, and a gate electrode of the MOS transistor is configured to receive a switch control signal of the third transistor switch unit.

3. The power divider according to claim 1, wherein

   the third transistor switch unit comprises two serially-connected metal oxide semiconductor MOS transistors, the two serially-connected MOS transistors comprise a first MOS transistor and a second MOS transistor, and a source electrode of the first MOS transistor is connected to a drain electrode of the second MOS transistor; and
   the first end of the third transistor switch unit is a drain electrode of the first MOS transistor, the second end of the third transistor switch unit is a source electrode of the second MOS transistor, and gate electrodes of the first MOS transistor and the second MOS transistor are separately configured to receive a switch control signal of the third transistor switch unit.

4. The power divider according to any one of claims 1 to 3, wherein
   transistors in the first transistor switch unit, the second transistor switch unit, and the third transistor switch unit are all N-type MOS transistors.

5. The power divider according to claim 4, wherein
   a channel width-to-length ratio of the MOS transistor in the third transistor switch unit is less than a channel width-to-length ratio of the MOS transistor in the first transistor switch unit and a channel width-to-length ratio of the MOS transistor in the second transistor switch unit.

6. The power divider according to any one of claims 1 to 5, wherein
   a value of an equivalent on-resistor of the third transistor switch unit is 100 ohms.

**7.** The power divider according to any one of claims 1 to 6, wherein
when the first transistor switch unit is in an off state, the second transistor switch unit is in an off state, and the third transistor switch unit is in an on state, the main port and the first branch port are connected to each other by using the first induction unit, and the main port and the second branch port are connected to each other by using the second induction unit.

**8.** The power divider according to any one of claims 1 to 6, wherein
when the first transistor switch unit is in an off state, the second transistor switch unit is in an on state, and the third transistor switch unit is in an off state, the main port and the first branch port are connected to each other by using the first induction unit, the second end of the second induction unit is grounded, and the main port and the second branch port are isolated from each other.

**9.** The power divider according to any one of claims 1 to 6, wherein
when the first transistor switch unit is in an on state, the second transistor switch unit is in an off state, and the third transistor switch unit is in an off state, the second end of the first induction unit is grounded, the main port and the first branch port are isolated from each other, and the main port and the second branch port are connected to each other by using the second induction unit.

**10.** The power divider according to any one of claims 1 to 9, wherein
the main port, the first branch port, and the second branch port are all differential ports.

**11.** A power dividing apparatus, comprising:

at least three power dividers according to any one of claims 1 to 10, wherein each of the at least three power dividers comprises a main port, a first branch port, and a second branch port, and the at least three power dividers comprise a first power divider, a second power divider, and a third power divider, wherein the first branch port of the first power divider is connected to the main port of the second power divider, and the second branch port of the first power divider is connected to the main port of the third power divider.

**12.** A wireless communication apparatus, comprising:
a transceiver, and the power dividing apparatus according to claim 11, wherein a main port of a first power divider is coupled to the transceiver through a circuit.

**13.** The wireless communication apparatus according to claim 12, further comprising:

an antenna array, wherein the antenna array comprises a first antenna unit, a second antenna unit, a third antenna unit, and a fourth antenna unit; and
a first branch port of a second power divider is coupled to the first antenna unit, a second branch port of the second power divider is coupled to the second antenna unit, a first branch port of a third power divider is coupled to the third antenna unit, and a second branch port of the third power divider is coupled to the fourth antenna unit.

**14.** The wireless communication apparatus according to claim 12 or 13, further comprising:
a control circuit, configured to output respective switch control signals of a first transistor switch unit, a second transistor switch unit, and a third transistor switch unit.

**15.** The wireless communication apparatus according to claim 14, comprising:
a radio frequency chip and a baseband chip, wherein the control circuit is integrated into the baseband chip, and the power dividing apparatus is integrated into the radio frequency chip.

10 → P1

Power divider

20 → P2

30 → P3

10 ← P1'

Power divider

20 ← P2'

30 ← P3'

FIG. 1

$\sqrt{2}Z_0, \lambda/4$

$\sqrt{2}Z_0, \lambda/4$

10

$Z_0$

20

$Z_0$

$R = 2Z_0$

30

$Z_0$

FIG. 2

FIG. 3

FIG. 4

FIG. 5

FIG. 6

FIG. 7

FIG. 8(a)

FIG. 8(b)

FIG. 9(a)

FIG. 9(b)

FIG. 10(a)

FIG. 10(b)

FIG. 10(c)

FIG. 11

**INTERNATIONAL SEARCH REPORT**

| International application No. |
| --- |
| **PCT/CN2019/130260** |

**A. CLASSIFICATION OF SUBJECT MATTER**

H03H 7/01(2006.01)i; H03F 3/20(2006.01)i; H01P 5/16(2006.01)i

According to International Patent Classification (IPC) or to both national classification and IPC

**B. FIELDS SEARCHED**

Minimum documentation searched (classification system followed by classification symbols)

H03H; H03F; H01P

Documentation searched other than minimum documentation to the extent that such documents are included in the fields searched

Electronic data base consulted during the international search (name of data base and, where practicable, search terms used)

CNPAT, WPI, EPODOC, CNKI: 功率, 分配, 分离, 功分器, 合成, 威尔金森, 电感, 电容, 集成度, 面积, 芯片, 端口, 晶体管, 接地, 截止, 导通, 开关, power, divider, spliter, combiner, wilkinson, MOS, inductor, capacitor, transistor, switch

**C. DOCUMENTS CONSIDERED TO BE RELEVANT**

| Category* | Citation of document, with indication, where appropriate, of the relevant passages | Relevant to claim No. |
| --- | --- | --- |
| Y | CN 107820647 A (TRUMPF HUTTINGER GMBH + CO., KG) 20 March 2018 (2018-03-20) description, paragraphs [0009]-[0068], figure 1 | 1-15 |
| Y | CN 102882479 A (TSINGHUA UNIVERSITY) 16 January 2013 (2013-01-16) description, paragraphs [0007]-[0014], and figures 1-3 | 1-15 |
| Y | CN 109546280 A (NANJING MILLIWAY MICROELECTRONIC SCIENCE AND TECHNOLOGY CO., LTD.) 29 March 2019 (2019-03-29) description, paragraphs [0002]-[0031], and figures 1-2 | 1-15 |
| A | CN 104022333 A (SUZHOU BOHAI CHUANGYE MICRO SYSTEM CO., LTD. et al.) 03 September 2014 (2014-09-03) entire document | 1-15 |
| A | US 2010210208 A1 (GORBACHOV, Oleksandr) 19 August 2010 (2010-08-19) entire document | 1-15 |

☐ Further documents are listed in the continuation of Box C.      ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 September 2020** | **27 September 2020** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2019/130260**

| Patent document cited in search report | | | Publication date (day/month/year) | Patent family member(s) | | | Publication date (day/month/year) |
|---|---|---|---|---|---|---|---|
| CN | 107820647 | A | 20 March 2018 | EP | 3317915 | A1 | 09 May 2018 |
| | | | | US | 2018123213 | A1 | 03 May 2018 |
| | | | | WO | 2017001595 | A1 | 05 January 2017 |
| | | | | DE | 102015212232 | A1 | 05 January 2017 |
| CN | 102882479 | A | 16 January 2013 | None | | | |
| CN | 109546280 | A | 29 March 2019 | WO | 2020119262 | A1 | 18 June 2020 |
| | | | | CN | 209374648 | U | 10 September 2019 |
| CN | 104022333 | A | 03 September 2014 | None | | | |
| US | 2010210208 | A1 | 19 August 2010 | US | 2010210299 | A1 | 19 August 2010 |
| | | | | WO | 2010096071 | A1 | 26 August 2010 |
| | | | | US | 2010210223 | A1 | 19 August 2010 |

Form PCT/ISA/210 (patent family annex) (January 2015)